# EUROPEAN PATENT APPLICATION

(11) **EP 2 749 526 A1**
(43) Date of publication of application: **02.07.2014**
(21) Application number: 13191191.9
(22) Date of filing: 31.10.2013
(51) Int. Cl.: B81B 3/00, G02B 26/08, G02B 26/10

(54) **Scanning mirror device**

(30) Priority: 27.12.2012 JP 2012283840
(71) Applicant: Funai Electric Co., Ltd., Daito city Osaka 574-0013 (JP)
(72) Inventor: Kugo, Kouichi, Osaka 574-0013 (JP)
(74) Representative: Osha Liang SARL

(57) **Abstract**

A scanning mirror device includes a mirror (1), a first supporting body (2) that supports the mirror (1), a plurality of securing materials (5) that has higher rigidity than the first supporting body (2) and supports the first supporting body (2), a reinforcing material (6) that has higher rigidity than the first supporting body (2) and is attached to the plurality of securing materials (5) on a surface different from a surface on which the mirror (1) is disposed, and a first driving portion (2a, 2b) configured to deform the first supporting body (2) so as to displace the mirror (1) around a first rotational axis (X).

## Description

### [Field of Technology]

The present invention relates to a scanning mirror device for displacing, around at least one axis, a mirror that reflects a light beam, as well as to an image displaying device comprising such scanning mirror device.

### [Background Art]

A scanning mirror device for causing a mirror that reflects a laser beam to undergo reciprocating displacements around two perpendicular axes to scan the reflected beam in the vertical and horizontal directions to display an image by the laser beam is used in image displaying devices such as, for example, laser projectors and the like.

Japanese Unexamined Patent Application Publication 2009-169290 discloses a deflecting device using a piezo actuator wherein a mirror portion and a piezo cantilever supporting body of the piezo actuator that drives the mirror portion are formed integrally by performing a shaping process on a semiconductor substrate formed from a plurality of layers. The piezo cantilever supporting body is formed by performing a forming process on a first supporting layer comprising at least one of the plurality of layers and the mirror portion is formed by performing a forming process on a second supporting layer formed from at least one of the plurality of layers having a thickness different from that of the first supporting layer.

In a scanning mirror device comprising a supporting body that supports a mirror reflecting a laser beam which undergoes reciprocating displacement in a horizontal scanning direction and a vertical scanning direction through deformation, in accordance with a driving signal, , there is the need to reduce the member mass and the moment of inertia in order to increase the resonant frequency of the driving signal to cause the reciprocating displacement of the mirror.

On the other hand, in order to cause the mirror to undergo displacement according to the design through deformation of the supporting body, it is necessary to limit the deformation of the supporting body to a specified level, and thus, in order to limit the deformation, a member with relatively high rigidity is provided as the supporting body.

It is desirable to meet both the need to provide a member with relatively high rigidity, in order to limit the deformation of the supporting body, and the need to reduce the mass and the moment of inertia of the supporting body, although these needs are in opposition to each other.

### [Summary of the Invention]

One or more embodiments of the present invention provide a high performance scanning mirror device.

In general, according to one or more embodiments, the scanning mirror device may comprise a mirror intended to reflect a light beam, such as for example a laser beam, and a first supporting body supporting the mirror. According to one or more embodiments, the first supporting body may support the mirror on at least two sides of the mirror, for example at opposite sides of the mirror. Further, the scanning mirror device may comprise at least one securing material, for example a plurality of securing materials, supporting the first supporting body and having higher rigidity than the first supporting body. According to one or more embodiments, the plurality of securing materials are coplanar with the first supporting body. According to one or more embodiments, the plurality of securing materials support the first supporting body at opposite sides of the first supporting body. Further, the scanning mirror device may comprise a reinforcing material attached to the plurality of securing materials on a surface different from a surface on which the mirror is disposed, the reinforcing material having higher rigidity than the first supporting body. According to one or more embodiments, the reinforcing material is attached to the plurality of securing materials on a surface opposite to the surface on which the mirror is disposed. Further, the scanning mirror device may comprise a first driving portion configured to deform the first supporting body so as to displace the mirror around a first rotational axis. For example, the mirror may undergo oscillating displacement around the first rotational axis. According to one or more embodiments, the first driving portion comprises a plurality of first driving portions, for example a pair of first driving portions, which may be for example arranged on opposite sides with respect to the mirror. According to one or more embodiments, the first driving portion(s) may be part of or may be the first supporting body. According to one or more embodiments, the first driving portion(s) may be distinct from the first supporting body. According to one or more embodiments, the first driving portion(s) may be formed integrally with the first supporting body. According to one or more embodiments, the first driving portion(s) may be coplanar with the first supporting body and optionally also with the securing materials. According to one or more embodiments, the first driving portion(s) may extend parallel to the first rotational axis. For example, the first rotational axis, in one or more embodiments, may extend in a horizontal scanning direction. In this manner, horizontal scanning of the light beam, for example a laser beam, that is reflected by the mirror may be obtained through deformation of the first supporting body.

In one or more embodiments, for example, the reinforcing material may be rigid and may limit deformation in the securing materials, i.e., limit the deformation of the first supporting body. The reinforcing material may be, for example, a rod-shaped member, for example a straight rod. For example, the reinforcing material may comprise a body in the form of a straight rod and two opposite ends perpendicular to the body and intended to be attached to the securing materials. In this manner, it is possible to reduce the mass and the moment of inertia.
In one or more embodiments, for example, two securing materials may be provided, so as to support the first supporting body at two places thereof. However, depending on the need to constrain the deformation of the first support body to a specified given level, the supporting body may be supported by one or more securing materials in less than or more than two places.

While functional components of a variety of types and shapes may be used as first driving portion, according to one or more embodiments, the size of the device can be reduced either by providing, on the first supporting body, a first driving portion of an auto-deforming type, such as for example a piezo-actuator, or by providing the first supporting body with a first driving portion of an auto-deforming type, such as for example a piezo-actuator.

According to one or more embodiments, the scanning mire device may further comprise a second supporting body supporting the first supporting body through the securing materials, the second supporting body having lower rigidity than the plurality of securing materials. According to one or more embodiments, the second supporting body may deform so as to displace the mirror around a second rotational axis. For example, the mirror may undergo oscillating displacement around the second rotational axis. For example, the second supporting body may act as a second driving portion configured to deform so as to displace the mirror, together with the first supporting body, around a second rotational axis. In this case, the second driving portion may be the second supporting body or may be part of the second supporting body. According to one or more embodiments, the second driving portion may be distinct from the second supporting body. For example, according to one or more embodiments, the scanning mirror device may further comprise a second driving portion configured to deform the second supporting body so as to displace the mirror, together with the first supporting body, around a second rotational axis. According to one or more embodiments, the second driving portion may be formed integrally with the second supporting body. According to one or more embodiments, the second driving portion comprises a plurality of second driving portions, for example a pair of second driving portions, which may be for example arranged on opposite sides with respect to the mirror. According to one or more embodiments, the second driving portion(s) may be coplanar with the first supporting body, and optionally also with the first driving portion(s) and/or with the securing materials. According to one or more embodiments, the second driving portion(s) may be parallel to the second rotational axis. According to one or more embodiments, the second rotational axis may extend perpendicularly to the first rotational axis.For example, the second rotational axis, in any of the above embodiments, may extend in a vertical scanning direction. In this manner, vertical scanning of the light beam, for example a laser beam, reflected by the mirror through deformation of the first supporting body may be obtained.
According to one or more embodiments, the first supporting body may have, through the reinforcing material, an increased rigidity. In this manner, the mirror may not deform unnecessarily, not even through the deformation of the second supporting body, when present, and the mirror can perform the desired vertical scanning and horizontal scanning.

While functional components of a variety of types and shapes may be used as second driving portion, according to one or more embodiments, the size of the device can be reduced easily either by providing, on the second supporting body, a second driving portion of an auto-deforming type, such as for example a piezo actuator or by providing the second supporting body with a second driving portion of an auto-deforming type, such as for example a piezo actuator.

According to one or more embodiments, the reinforcing material and the first supporting body and second supporting body may be formed through a variety of materials, and the reinforcing material may have a relatively high rigidity, and the first supporting body and the second supporting body may have a relatively low rigidity. According to one or more embodiments, the scanning mirror device may be for example an MEMS (Micro Electro Mechanical System) scanning mirror device. The MEMS-type scanning mirror device may have a size of, for example, about 10 mm x 10 mm. The scanning mirror device, for example in the form of a MEMS scanning mirror device, may be formed using a thin-film forming technology for semiconductor materials, such as silicon, or a thin-film forming technology for metals. For example, the reinforcing material may be formed from silicon and the first supporting the body and second supporting body may be formed from metal. In this manner, the respective required rigidities are obtained in an easy manner.

According to one or more embodiments, the scanning mirror device may be formed so as to avoid that the reinforcing material overlaps the mirror in the direction normal to the mirror. In this manner, it is possible to assemble the mirror easily, and both the front and the back of the mirror may be used to reflect the light beam, for example a laser beam.
According to one or more embodiments, the reinforcing material may be curved so as to avoid overlapping with the mirror, or may have a shape with an opening portion corresponding to the mirror.

According to one or more embodiments, at least a portion of any reinforcing material that overlaps with the mirror in the direction normal to the mirror may be formed from a transparent material. In this manner, both the front and the back of the mirror may be used to reflect the light beam, for example a laser beam.

In general, one or more embodiments of the present invention are directed to an image displaying device comprising a scanning mirror device as described above.
The image displaying device, according to one or more embodiments, may be an image displaying device for displaying an image by emitting a laser beam and reflecting the laser beam by causing a mirror to undergo scanning displacement, comprising: a first supporting body that supports the mirror; a plurality of securing materials that has higher rigidity than the first supporting body and supports the first supporting body; a reinforcing material that has higher rigidity than the first supporting body and is attached to the plurality of securing materials on a surface different from a surface on which the mirror is disposed; a first driving portion configured to deform the first supporting body so as to displace the mirror around a first rotational axis. In this manner, horizontal scanning displacement may be performed.
According to one or more embodiments, the image displaying device may further comprise a second supporting body that has lower rigidity than the plurality of securing materials and the reinforcing material and that supports the first supporting body through the plurality of securing materials, and a second driving portion configured to deform the second supporting body so as to displace the mirror, together with the first supporting body, around a second rotational axis. In this manner, vertical scanning displacement may be performed.
Further embodiments are defined by the dependent claims.

One or more embodiments of the present invention may enable an improvement in the performance of a scanning mirror device wherein a mirror is displaced through deformation of a supporting body.

### [Brief Descriptions of the Drawings]

FIG. 1 is a perspective view of a scanning mirror device according to a first embodiment of the present invention.
FIG. 2 is a perspective view illustrating a portion of a scanning mirror device according to the first embodiment of the present invention.
FIG. 3 is a perspective view of the scanning mirror device according to the first embodiment of the present invention viewed from the back side.
FIG. 4 shows two views of a portion of the scanning mirror device according to the first embodiment of the present invention, wherein Fig. 4(a) is a cross-sectional view and Fig. 4(b) is a plan view.
FIG. 5 is a perspective diagram viewing the scanning mirror device according to a second embodiment of the present invention viewed from the back side.
FIG. 6 shows two views of a portion of the scanning mirror device according to a second embodiment of the present invention, wherein Fig. 6(a) is a cross-sectional view and Fig. 6(b) is a plan view.
FIG. 7 is a perspective view of the scanning mirror device according to a third embodiment of the present invention viewed from the back side.
FIG. 8 shows two views of a portion of the scanning mirror device according to third embodiment of the present invention, wherein Fig. 8(a) is a cross-sectional view and Fig. 8(b) is a plan view.

### [Detailed Description of Embodiments of the Invention]

Embodiments of the present invention will be explained based on examples.
The scanning mirror device may comprise a mirror intended to reflect a light beam, such as for example a laser beam, a first supporting body supporting the mirror, a plurality of securing materials attached to the first supporting body, and a reinforcing material attached to these securing materials. The plurality of securing materials have higher rigidity than the first supporting body. Further, The reinforcing material, which has higher rigidity than the first supporting body, may be attached to the plurality of securing materials on a surface different from a surface on which the mirror is disposed. Further, the scanning mirror device may comprise a first driving portion configured to deform the first supporting body so as to displace the mirror around a first rotational axis.

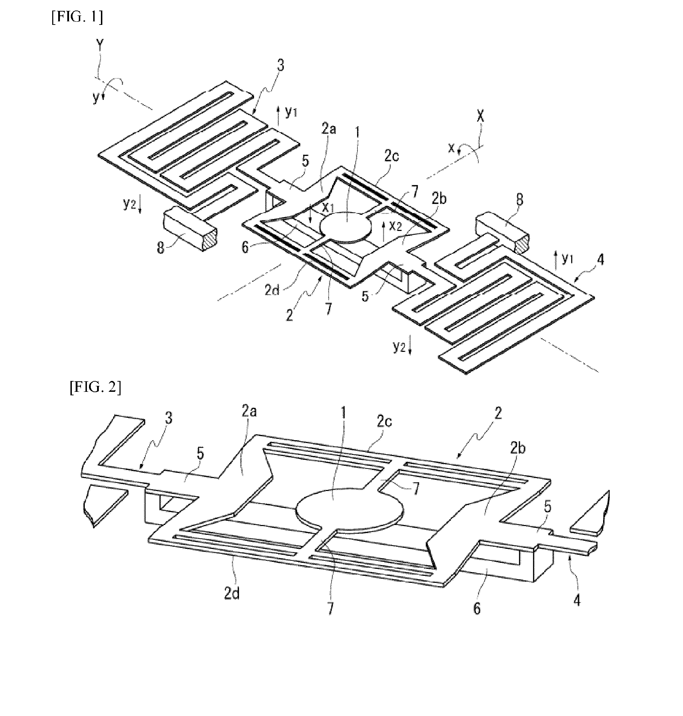

FIG. 1 through FIG. 4 illustrate a scanning mirror device according to a first embodiment of the present invention.
In this embodiment, the scanning mirror device comprises a mirror 1, for example in the form of a disc, a first supporting body 2, for example in the form of a frame, a pair of second supporting bodies 3 and 4, for example in the form of serpentines, a pair of securing materials 5 attached to the first supporting body 2 and the second supporting bodies 3 and 4, and a reinforcing material 6 attached to these securing materials 5.

The scanning mirror device may be fabricated using a thin-film forming technology for semiconductor materials, such as silicon, or a thin-film forming technology for metals. The individual structures described above may be formed on, for example, a silicon substrate (Si substrate) as first supporting body 2. The silicon substrate may have a thickness of about 0.1 mm. For example, the first supporting body 2 may have a thickness of about 0.1 mm and an outside shape of about 10 mm x 10 mm, excluding the first driving portion described above.
The scanning mirror device may be an MEMS-type scanning mirror device, and may have benefits in terms of reducing size, reducing power consumption, increasing processing speed, and the like.

As illustrated in the example of FIG. 1, the mirror 1 may undergo reciprocating movement or displacement using, as rotational axes, two perpendicular rotational axes X and Y passing through the center of the disc-shaped mirror 1. The mirror 1 may be positioned in the plane defined by the axes X and Y. The first supporting body 2, the second supporting bodies 3 and 4, and the securing materials 5 may also be positioned in the same plane as the mirror 1.
The reinforcing material 6 may be attached to the securing materials 5 at a surface different from the surface on which the mirror 1 is arranged. In FIG. 1, the reinforcing material 6 is attached to the securing materials 5 at a surface opposite to the surface on which the mirror 1 is arranged.

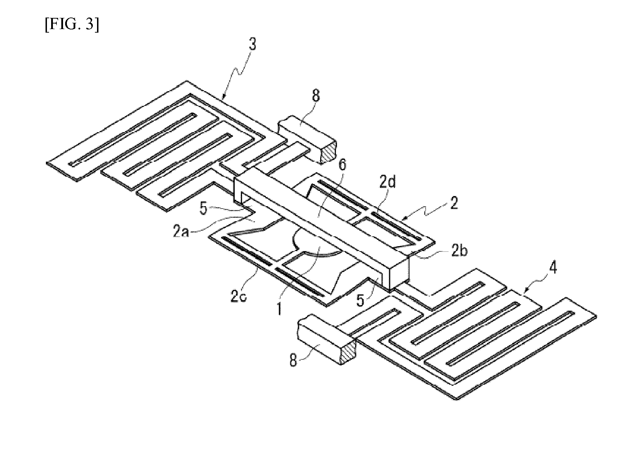

The mirror 1 may be given a mirror surface treatment through, for example, the fabrication of a metal thin-film on an Si substrate, where a laser beam incident on the mirror surface is reflected.
The mirror 1 may be for example provided with a mirror surface on the front face side as illustrated in FIG. 1 and FIG. 2, and may not be provided with a mirror surface on the back face side, as illustrated in FIG. 3.

The first supporting body 2 may be formed in a frame shape from a pair of first driving portions 2a and 2b parallel to the rotational axis X, and a pair of attaching portions 2c and 2d that connect together both end portions of the first driving portions 2a and 2b. Each of these portions 2a through 2d may be formed with relatively low rigidity, and the first supporting body 2 itself may be deformable.
The first driving portions 2a and 2b may be provided with protrusions protruding in a flange shape. The first driving portions 2a and 2b may comprise piezoelectric actuators each including a bottom electrode layer, a piezoelectric body layer, and a top electrode layer provided as a thin layered body on a substrate, for example a Si substrate.

When voltages of mutually opposite phases are applied to the first driving portions 2a and 2b, the piezoelectric body layers may extend or contract depending on the voltage, so that the first driving portion 2a and the second driving portion 2b repetitively deform in mutually opposite directions in directions orthogonal to the rotational axes X and Y (i.e. in the direction x1and in the direction x2 shown in FIG. 1).
The piezoelectric body layer of the piezoelectric actuator may be made from, for example, lead zirconate titanate (PZT), and, by being polarized in the direction of thickness of the film layer, may extend or contract when a voltage is applied.
Such a piezoelectric actuator may be per se well-known, as disclosed, for example, in Japanese Unexamined Patent Application Publication 2011-141333.

When, as described above, the first driving portions 2a and 2b are deformed repetitively in opposite directions (the direction x1 and the direction x2), the attaching portions 2c and 2d may be tilted, through these deformations, centered on the rotational axis X. The mirror 1 may be attached to the attaching portions 2c and 2d through a pair of bars 7, which may extend along the rotational axis X. The tilting of the attaching portions 2c and 2d centered on the rotational axis X may cause the mirror 1 to undergo rotational displacement around the rotational axis X.
As illustrated in FIG. 1, when the first driving portion 2a deforms in the direction xland the first driving portion 2b deforms in the direction x2, the mirror 1 may undergo rotational displacement in the direction x around the rotational axis X, and, conversely, when the first driving portion 2a deforms in the direction opposite to the direction x1 and the first driving portion 2b deforms in the direction opposite to the direction x2, the mirror 1 may undergo rotational displacement in the direction opposite to the direction x, around the rotational axis X. Consequently, the mirror 1 can be displaced around the rotational axis X through the deformation of the first supporting body 2 itself.

The mirror 1 can be rotationally displaced in the opposite direction as described above, around the rotational axis X, by reversing the voltages applied to the first driving portions 2a and 2b.
Consequently, it is possible control the voltages applied to the first driving portions 2a and 2b to displace the mirror 1 around the rotational axis X to scan a laser beam incident on the mirror 1. For example, if the scanning direction is the horizontal scanning direction, then the laser beam is scanned in the horizontal direction through control of the voltages applied to the first driving portions 2a and 2b.

As with the first supporting body 2, the second supporting bodies 3 and 4 may be formed with relatively low rigidity, and the second supporting bodies 3 and 4 themselves may deform. For example, the second supporting bodies 3 and 4 may comprise piezoelectric actuators formed on a substrate, for example a Si substrate. The piezoelectric actuators may comprise a bottom electrode layer, a piezoelectric body layer, and a top electrode layer provided as a layered body. The second supporting bodies 3 and 4 may be formed so that both end portions thereof are displaced in opposite directions (the direction y1 and the direction y2 shown in FIG. 1) when the piezoelectric body layers extend or contract in response to voltages when voltages are applied, so that the second supporting bodies 3 and 4 tilt, as a whole, around the rotational axis Y.
In the present embodiment, the second supporting bodies 3 and 4 may form second driving portions that deform so as to cause the first mirror to displace, together with the first supporting body 2, around the rotational axis Y perpendicular to the rotational axis X.

As described above, the tilting of the second supporting bodies 3 and 4 may cause the first supporting body 2, which is attached through securing materials 5, to tilt as a whole around the rotational axis Y, and the mirror 1 may be rotationally displaced around the rotational axis Y.
As illustrated in FIG. 1, when one end portion of the second supporting bodies 3 and 4 deforms and is displaced in the direction y1 and the other end portion of the second supporting bodies 3 and 4 deforms and is displaced in the direction y2, then the mirror 1 may undergo rotational displacement in the direction y around the rotational axis Y, and, conversely, when the one end portion of the second supporting bodies 3 and 4 undergoes deformation and displacement in the direction opposite to the direction y1 and the other end portion of the second supporting bodies 3 and 4 undergoes deformation and displacement in the direction opposite to the direction y2, then the mirror 1 may undergo rotational displacement in the direction opposite to the direction y around the rotational axis Y. This makes it possible for the mirror 1 to be displaced around the rotational axis Y through the deformation of the second supporting bodies 3 and 4 themselves.

The voltages applied to the second supporting bodies 3 and 4 can be reversed and displaced rotationally the mirror 1 around the rotational axis X in the opposite direction to that which is described above.
Consequently, the mirror 1 can be displaced around the rotational axis Y, to scan the laser beam incident on the mirror 1, by controlling the voltages applied to the second supporting both bodies 3 and 4. If, for example, this scanning direction is the vertical scanning direction, the laser beam is scanned in the vertical direction by controlling the voltages applied to the second supporting bodies 3 and 4.

As described above, the mirror 1 can be caused to be displaced rotationally around the rotational axis X through the deformation of the first supporting body 2, and the mirror 1 can be caused to be displaced rotationally around the rotational axis Y through the deformation of the second supporting bodies 3 and 4.
In these second supporting bodies 3 and 4, the base ends may be attached to an external frame 8 having relatively high rigidity, and the first supporting body 2 may be supported, through the securing materials 5, by the tip ends thereof.
It is possible to increase the rigidity of the securing materials 5 to be higher than that of the first supporting body 2 or the second supporting bodies 3 and 4 by, for example, increasing the thickness through depositing an SiO layer on a Si layer, or through depositing a metal layer on the Si layer.
Moreover, while in the present example the securing materials 5 are provided in two locations on the rotational axis Y to attach the first supporting body 2 and the second supporting bodies 3 and 4, depending on the need in the device design, or the like, the securing materials 5 may be provided in three or more required locations.

The securing materials 5 may be attached through a frame with high rigidity such as one encompassing the first supporting body 2.

For example, in a two-axis scanning piezoelectric MEMS scanning mirror device as described above, there is the need to increase the resonant frequency while obtaining a large deflection angle on the low speed scanning axis (the vertical scanning axis). Because of this, in an image displaying device provided with a scanning mirror device, it is possible to scan the low speed scanning axis even with a waveform that includes a segment that has high acceleration, such as a sawtooth wave. If the scanning could only be performed with low acceleration, then the scanning waveform in the vertical direction would be near to a sine wave, so the scanning spacing at the top and bottom edges of the projection screen, or the like, would not be uniform, which would cause a loss in quality in the image projected by the mirror 1, but if scanning could be performed at a high speed, then the scanning could be performed with essentially uniform spacing. Moreover, because this would allow the mirror 1 to be returned to the origin over a short blanking period, a long time interval could be used in drawing in the image.

As another example, a reinforcing material 6 with relatively high rigidity may be attached to the securing materials 5 on a surface different from the plane in which the mirror 1 is arranged.
The reinforcing material 6 may be a straight rod extending below the back face side of the mirror 1. When compared to the case of attaching the securing materials 5 by a frame, the mass may be reduced and the moment of inertia may be reduced by concentrating the mass near the rotational axis Y, thus making it possible to operate the mirror 1 with a high-frequency driving signal while obtaining a large deflection angle (scanning displacement amplitude).

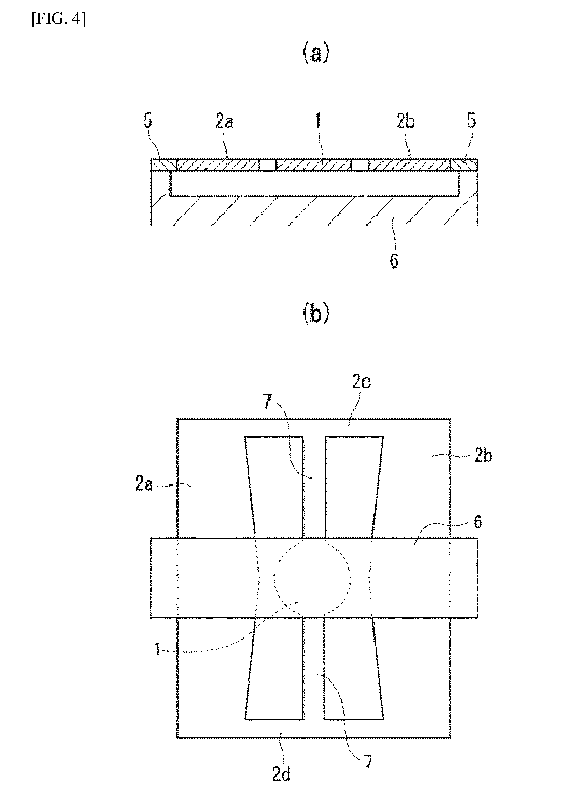

Although, as illustrated in FIG. 4, the reinforcing material 6 may overlap the mirror 1 in the direction normal to the mirror 1, the reinforcing material 6 may also be provided below the back face side of the mirror 1 so as not to interfere with the reflection of the laser beam by the mirror surface of the mirror 1.

The reinforcing material 6 may be resistant to deformation by forces such as compression, tension, twisting, and the like, and can be fabricated from a variety of materials insofar as they have these properties. For example, the reinforcing material 6 may be formed from a material with a large modulus of elasticity (Young's modulus/density) when compared to that of the easily deformed first supporting body 2 and second supporting bodies 3 and 4.
Moreover, the easily deformed first supporting body 2 and second supporting bodies 3 and 4 may be formed from metal, and the reinforcing material 6 may be formed from silicon. Such a structure may be manufactured easily using a thin film forming technology for a semiconductor material such as silicon and a thin film forming technology for metal. This may improve the ability to withstand physical shock and durability, and has the benefit of reducing materials costs.

The reinforcing material 6 may be formed integrally with the securing materials 5. However, , the reinforcing material may also be formed as a separate component and the reinforcing material 6 may be attached through adhesion, or the like, to the securing materials 5.

The scanning mirror device set forth above can be provided in an image displaying device such as a laser projector, or the like, making it possible to increase the oscillating frequency while obtaining a high deflection angle on the low speed scanning axis of the mirror 1, while preventing extraneous oscillation in non-sinusoidal scanning.

For example, in an image displaying device that displays an image by emitting a laser beam, based on a video signal, and causing a mirror to undergo scanning displacement to reflect the laser beam, the device may comprise a first supporting body 2 that supports a mirror 1 and that deforms to cause the mirror 1 to undergo scanning displacement around a first rotational axis X (for example, a horizontal scanning axis), securing materials 5 that support the first supporting body 2, a reinforcing material 6 attached to the securing materials 5 on a surface different from the surface on which the mirror 1 is disposed, and second supporting bodies 3 and 4 that support the first supporting body 2, through the securing materials 5, and that undergo deformation to cause the mirror 1, together with the first supporting body 2, to undergo scanning displacement around a second rotational axis Y (for example, a vertical scanning axis).

For example, for scanning around the horizontal scanning axis (the first rotational axis X), the piezoelectric actuator of the first supporting body 2 may be resonance driven at a resonant frequency of about 30 kHz to cause the mirror 12 undergo reciprocating displacement at a relatively high speed. For scanning around the vertical scanning axis (the second rotational axis Y), the piezoelectric actuators of the second supporting bodies 3 and 4 may be resonance driven to cause the mirror 1 to undergo reciprocating displacement at a relatively low speed.

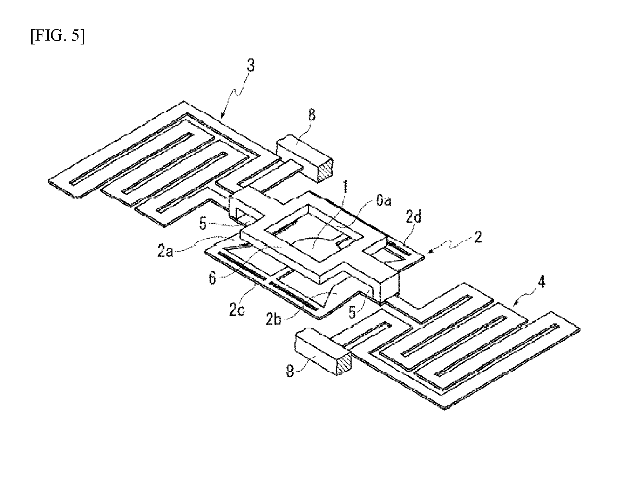

The reinforcing materials 6 may be provided below the back face side of the mirror 1 so as to overlap the mirror 1, as discussed above, or instead, as illustrated in FIG. 5 through FIG. 8, for example, may be formed so as to avoid any overlapping with the mirror 1 in the direction normal to the mirror 1.

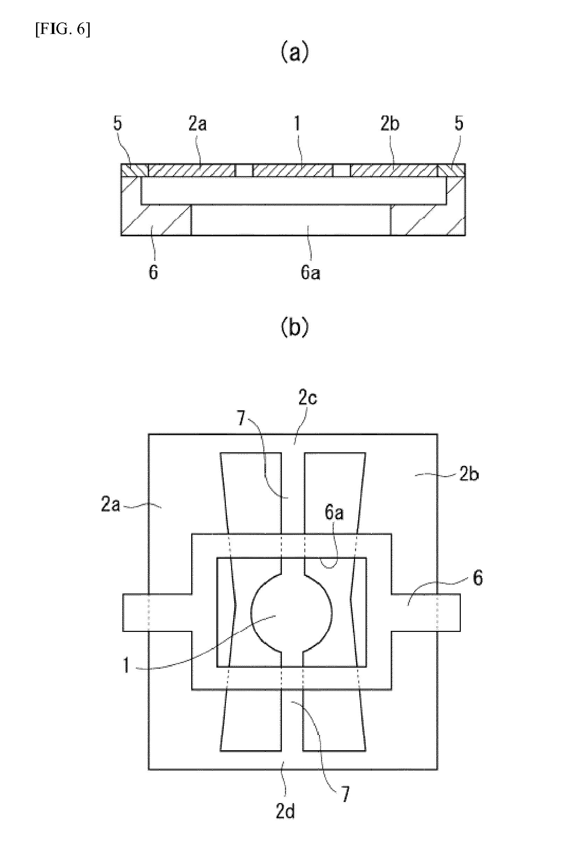

An example of a scanning mirror device according to a second embodiment of the present invention is illustrated in FIG. 5 and FIG. 6.
Those portions that are identical to those described with reference to the first embodiment set forth above, are assigned identical codes and redundant explanations are omitted.
In the present embodiment, the reinforcing material may be shaped by forming an opening portion 6a in the center portion of the reinforcing material, to avoid any overlapping between the reinforcing material 6 and the mirror 1.

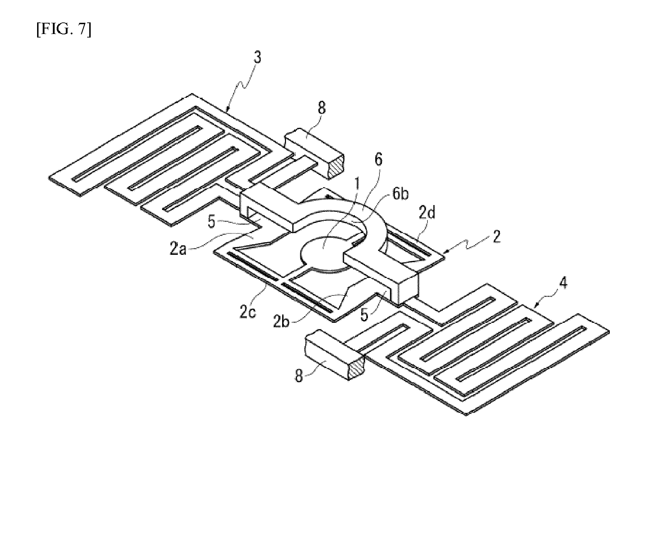

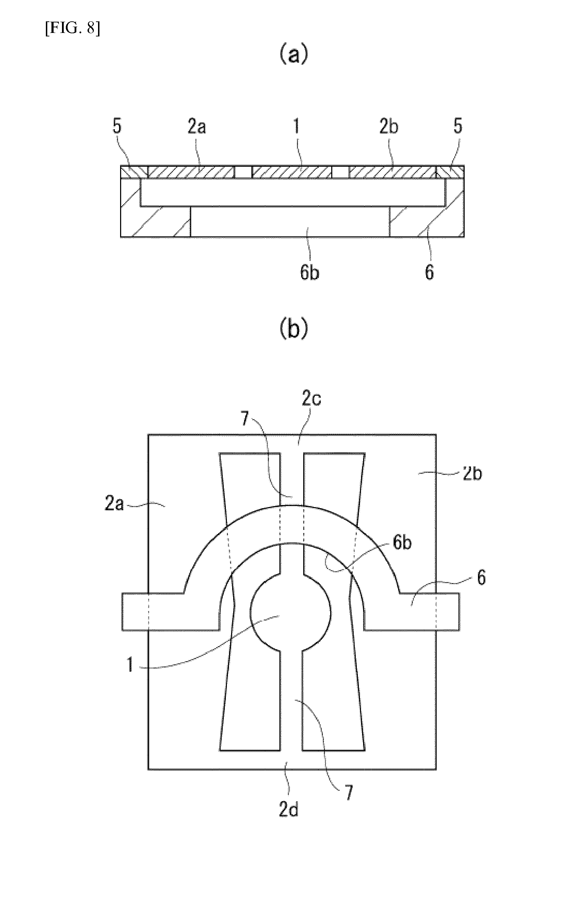

An example of a scanning mirror device according to a third embodiment of the present invention is illustrated in FIG. 7 and FIG. 8.
Those portions that are identical to those in the first embodiment, set forth above, are assigned identical codes and redundant explanations are omitted.
In the present embodiment, the reinforcing material 6 may be shaped by forming a curved portion 6b in the center portion of the reinforcing material 6, to avoid any overlapping between the reinforcing material 6 and the mirror 1.

The shape of the reinforcing material 6 so as to avoid overlapping the mirror 1 in the direction normal to the mirror 1 can be based on a variety of shapes other than the examples set forth above.
Moreover, instead of avoiding overlapping between the reinforcing material 6 and the mirror 1 through the shape of the reinforcing material 6, the reinforcing material 6 may overlap the mirror 1. In this case, at least that portion of the reinforcing material 6 that overlaps the mirror 1 in the direction normal to the mirror 1 may be for example formed from a transparent material.

When the reinforcing material 6 does not overlap the mirror 1 on the back face side of the mirror 1, or when the portion of reinforcing material 6 that overlaps in the direction normal to the mirror 1 is transparent, it is possible to provide a mirror face on the back face of the mirror 1, so as to use both the front and back faces of the mirror 1 to reflect the laser beam. For example, the use of both the front and back sides of the mirror 1 in scanning the laser beam can reduce the size and the cost of the equipment.
While the invention has been described with respect to a limited number of embodiments, those skilled in the art, having benefit of this disclosure, will appreciate that other embodiments can be devised which do not depart from the scope of the invention as disclosed in the claims. Accordingly, the scope of the invention should be limited only by the attached claims.

### [Explanation of Reference Numbers]

1: Mirror
2: First Supporting Body
2a, 2b: First Driving Portions
3, 4: Second Supporting Bodies (Second Driving Portions)
5: Securing Materials
6: Reinforcing Material
6a: Opening Portion
6b: Curved Portion
X: First Rotational Axis
Y: Second Rotational Axis

## Claims

1. A scanning mirror device comprising:
a mirror (1);
a first supporting body (2) that supports the mirror (1);
a plurality of securing materials (5) that has higher rigidity than the first supporting body(2) and supports the first supporting body (2);
a reinforcing material (6) that has higher rigidity than the first supporting body (2) and is attached to the plurality of securing materials (5) on a surface different from a surface on which the mirror (1) is disposed; and
a first driving portion (2a, 2b) configured to deform the first supporting body (2) so as to displace the mirror (1) around a first rotational axis (X).

2. The scanning mirror device of claim 1, wherein the first supporting body (2) comprises the first driving portion (2a, 2b).

3. The scanning mirror device of claim 1 or of claim 2, wherein the first supporting body (2) supports the mirror (1) at opposite sides of the mirror (1).

4. The scanning mirror device of any of claims 1-3, wherein the first driving portion (2a, 2b) comprises a plurality of first driving portions (2a, 2b) arranged parallel to the first rotational axis (X).

5. The scanning mirror device of any of claims 1-4, further comprising:
a second supporting body (3, 4) that has lower rigidity than the plurality of securing materials (5) and the reinforcing material and that supports the first supporting body (2) through the plurality of securing materials (5); and
a second driving portion that causes the second supporting body (3, 4) to deform to cause the mirror (1), together with the first supporting body (2), to be displaced around a second rotational axis (Y) perpendicular to the first rotational axis (X).

6. The scanning mirror device of any of claims 1-4, further comprising:
a second supporting body (3, 4) that has lower rigidity than the plurality of securing materials (5) and the reinforcing material and that supports the first supporting body (2) through the plurality of securing materials (5).

7. The scanning mirror device of any of claims 1-4, further comprising a second driving portion (3, 4) configured to deform so as to displace the mirror (1), together with the first supporting body (2), around a second rotational axis (Y).

8. The scanning mirror device of claim 7, wherein the second rotational axis (Y) is perpendicular to the first rotational axis (X).

9. The scanning mirror device of any of claim 5 or claim 7 or claim 8, wherein the second driving portion (3, 4) comprises a plurality of second driving portions (3, 4) arranged parallel to the second rotational axis (Y).

10. The scanning mirror device of any of claims 1-9, wherein
the reinforcing material (6) is formed from silicon.

11. The scanning mirror device of any of claims 1-10, wherein the first supporting body (2) and the second supporting body (3, 4) are formed from metal.

12. The scanning mirror device of any of claims 1-11, wherein
the reinforcing material (6) is formed so as not to overlap with the mirror (1) in a direction normal to the mirror (1).

13. The scanning mirror device of any of claims 1-11, wherein
at least a portion of any reinforcing material (6) that overlaps with the mirror (1) in the direction normal to the mirror (1) is formed from transparent material.

14. The scanning mirror device of any of claims 1-13, wherein
the plurality of securing materials (5) supports the first supporting body (2) in a plurality of areas on the first supporting body (2).

15. An image displaying device for displaying an image by emitting a laser beam and reflecting the laser beam by causing a mirror (1) to undergo scanning displacement, wherein the image displaying device comprises the scanning mirror device of any of claims 1-14.
